# EUROPEAN PATENT SPECIFICATION

(11) **EP 1 983 812 B1**
(45) Date of publication and mention of the grant of the patent: **20.11.2013**
(21) Application number: 07106249.1
(22) Date of filing: 16.04.2007
(51) Int. Cl.: H05K 7/14

(54) **An intelligent electronic device for substation or distribution automation systems**
Intelligente elektronische Vorrichtung für eine Substation oder Verteilungsautomatisierungssysteme
Dispositif électronique intelligent pour une sous-station ou des systèmes de distribution automatisés

(43) Date of publication of application: 22.10.2008
(73) Proprietor: ABB RESEARCH LTD., 8050 Zürich (CH)
(72) Inventor: Balgard, Lennart, 73232 Arboga (SE); Shah, Vijay, 390022 Baroda Gujarat (IN); Deck, Bernhard, 79809 Weilheim (DE); Rudolf, Paul, 5234 Villigen (CH)
(74) Representative: ABB Patent Attorneys

(56) References cited:
- EP-A- 1 355 523
- WO-A-97/10692
- WO-A1-02/054562

## Description

### FIELD OF THE INVENTION

The invention relates to the field of automated power transmission and distribution systems. It departs from a digital device for Substation Automation (SA) or Distribution Automation (DA) systems as described in the preamble of claim 1.

### BACKGROUND OF THE INVENTION

An electric power system comprises a power transmission and/or distribution network interconnecting geographically separated regions, and a plurality of substations at the nodes of the power network. The substations include equipment for transforming voltages and for switching connections between individual lines of the power network. They comprise primary devices such as electrical cables, lines, bus bars, switches (breakers or disconnectors), power transformers and instrument transformers which are generally arranged in switch yards and/or bays. These primary devices are operated in an automated way via a Substation Automation (SA) or Distribution Automation (DA) system responsible for controlling, protecting, measuring and monitoring of substations. The automation system comprises secondary devices interconnected in a SA communication network and interacting with the primary devices via a process interface.

In automated power transmission and distribution, the secondary devices comprise microprocessor-based programmable electronic devices or digital relays that are capable of sending control signals to switching devices, such as circuit breakers and disconnectors. Most digital relays in use today combine protection, control, monitoring, communications, power quality monitoring, and metering capabilities. The protection functions supported by a digital relay may include time delay and instantaneous over-current functions for phase and ground elements, sequence directional over-current functions, reclosing functions, over- and under-frequency protection functions, and over- and under-voltage protection functions. Digital relays also support various metering functions; monitoring of voltage sags, swells, and interruptions; fault location algorithms; and oscillographic record storage, and are configured locally using the front panel of the protection device or remotely using a settings software tool. In many cases the required protection functionality is preloaded in the device, and later enabled and parameterised with a tool connected to the protection device. Without this tool or other human machine interface however, a user can not discern what function the device has actually programmed or enabled.

In short, a basic function of these protection devices is to protect electrical equipment by tripping a circuit breaker and interrupting a power line. The tripping signal is generated by the digital relay typically when the measured current in the line exceeds a nominal or setting value for a predefined time period.

The protection devices described above may have different kinds of interfaces depending on the intended application. The interfaces are binary inputs, binary outputs, analog inputs, analog outputs, communication interfaces, power supplies, trip indicators, human machine interfaces and also SW functions. The analog inputs are typically connected to different sensor types and primary transducer means placed on the power line, such as current transformers (CT) and voltage transformer (VT), or non-conventional transducer means like Rogowski coils, Hall sensors and voltage dividers.

Standard digital protection devices in the field of automated power transmission and distribution systems are designed semi-modular and use a single electrically insulating cover or cabinet to enclose all the modules. However, employing a cover of given dimensions ultimately limits the number of modules, constrains their mutual arrangement and complicates replacement or extension of individual modules.

The process automation industry uses so-called modular remote Input/Output (I/O) systems for controlling industrial processes. To the purpose of remote signal processing, the company Moeller GmbH (www.moeller.net), in their catalogue "Automation Product Overview", 2005, pages 65-69, offers a range of digital and analog I/O and technology modules. Typically, the analog I/O modules are restricted to current signals between 4 and 20 mA and to voltage signals between -10 and +10 VDC. The modules are to be mounted on an inverted hat rail as a mechanical support. The modules are linked, via an internal module bus, to each other and, via gateways, to different field bus systems and to a centralized operator work station. Power feeding modules supply I/O modules with a rated voltage of up to 230 V, hence an electrical insulation withstanding 500 V at the analog inputs is sufficient. However, these systems have been developed for and adapted to the needs of process automation in industrial applications, and their use in a substation for electrical power distribution with voltage levels in excess of 1 kV and the stringent environmental requirements (humidity, dust, low temperatures) is not envisaged.

Substation automation systems require interoperability between all substation devices independently of their manufacturer. To that effect, an internationally accepted communication standard for communication between the secondary devices of a substation has been introduced under the name of IEC 61850 "communication networks and systems in substations". IEC 61850 defines an abstract object model for compliant substations, and a method how to access these objects over a network. The abstract object model represents the functionality in terms of logical nodes within logical devices that in turn are allocated to the protective devices as the physical devices. The actual communication between the devices is handled, for non-time critical messages, via an MMS communication stack built on OSI/TCP/IP/Ethernet, or for time critical messages, via so-called Generic Object Oriented Substation Events (GOOSE) that build directly on the Ethernet link layer of the communication stack. All IEC 61850 compliant secondary devices connected to the SA communication network, including but not limited to digital relays as introduced above, are called Intelligent Electronic Devices (IED).

The IEC 61850 Substation Configuration Language (SCL) provides for a standardized description of the primary devices, the secondary devices with their Protection, Control and Monitoring (PCM) functions, the communication system logical structure and the relation between primary and secondary devices, including data attributes carried by the instances related to particular devices, e.g. values for configuration attributes and setting parameters. A Substation Configuration Description (SCD) file in SCL language describes, for a particular substation, the primary objects, the functions implemented in each protective device in terms of logical nodes, and the communication connections. The connection between the power process and the SA system is described in the SCL language by allocating or attaching logical nodes to elements of the primary equipment. Typically, a switch control logical node is attached to a switching device, whereas a measurement logical node is allocated to an instrument transformer.

WO 02/054562 A1 discloses an Intelligent Electronic device according to the preamble of claim 1.

### DESCRIPTION OF THE INVENTION

It is an objective of the invention to create secondary devices for Substation Automation (SA) or Distribution Automation (DA) which are flexible and which can be easily extended and maintained. These objectives are achieved by an Intelligent Electronic Device (IED) and an input module according to the claims 1 and 8, respectively. Further preferred embodiments are evident from the dependent patent claims.

According to the invention, an Intelligent Electronic Device (IED) according to claim 1 such as a digital relay or protection device for Substation or Distribution Automation is conceived in a modular way, comprising distinct modules dedicated to distinct tasks and having dedicated housings or casings, which modules are mechanically arranged on a common support and both visible and accessible from outside of the IED at all times. Modules for signal input (process interface module) and signal processing (process data handling module) define the basis of a modular arrangement that is not delimited by any prefabricated cover or cabinet and that allows for a quasi-unlimited number of modules, and easy replacement or extension of individual modules.

The basic input functionality is provided by a binary or analogue input module comprising a number of input terminals and some signal conditioning facility for converting, storing, or time-stamping the input signal. The basic processing functionality is provided by a protection module for evaluating the signal in view of an automated protection function, or a communication gateway for communicating the signal to a substation bus. In the latter case, the IED represents an intelligent decentralized process interface, comprising an arbitrarily extendable number of I/O modules and the gateway connecting to a centralized computer for carrying out the protection functionality.

Besides the basic modules mentioned, the IED may comprise any number of other modules with each a dedicated functionality, such as binary output, analogue output e.g. for producing a trigger signal on behalf of an actuator, power supply, trip indicator, or human machine interface. The modules can be placed on the mechanical support in an arbitrary order and the sum of the modules defines the function of the IED.

In a first preferred embodiment, considering the fact that the intended application in Substation or Distribution Automation by definition involves voltage levels above 1 kV, the signal input terminals, i.e. the screw or clamp connectors for the wires coming from the sensor, are such as to ensure a voltage insulation between two terminals, and/or between a terminal and Protective Earth (PE), of at least 2 kV. As a consequence, the internal circuitry on a PCB of the module is advantageously arranged such as to respect a lateral separation of at least 4 mm in order to prevent surface leakage currents.

The different modules of the IED are connected via an inter-module bus for inter-module communication. In a second preferred embodiment, the latter involves, as the physical communication media, a segmented backplane that is created on-site by placing the individual modules next to each other and establishing an electrical contact between the parts or segments of the backplane that are incorporated in the different individual modules. This avoids the need for an additional manufacturing step consisting of the mounting of a non-segmented backplane, such as a wave guide or optical fibre, either on the mechanical support or on the top, front or bottom side of the mounted modules, and further contributes to an enhanced flexibility.

In a third preferred embodiment, all or some of the modules are constructed in such a way that an electronic part or electronic sub-module can be exchanged without removing the cabling or cable installation of the module. To this end, all cable terminals of one module are grouped to a base part or base sub-module that is directly mounted on the mechanical support, whereas the electronic part is confined in a dedicated housing that itself is plugged to the base part. As in general the electronic parts have a lower Mean Time Between Failure (MTBF) than the mechanical parts, the base part may remain in place during maintenance operations directed to the electronic parts. In the present context, the electronic or intelligent part of the I/O modules comprises the signal conditioning facility, i.e. an A/D or D/A converter for analogue I/Os connected to an instrument transformer or a gas density or other sensor or actuator, or a time-stamping and data storage means for binary I/Os continuously monitoring or providing/outputting a binary signal, registering changes and indicating a quality status. On the other hand, the terminals of a processing module assigned to the base part are e.g. an interface to an HMI or sockets for function coding or activation keys as detailed next.

In an advantageous variant of the invention, a processing module comprising a CPU is further adapted for receiving function coding or activation keys. The latter may be inserted into or otherwise coupled to the processing module and in particular cooperate with a dedicated socket in the base sub-module. They enable a single one or a set of protection function(s) by activating, upon transfer of an activation code from the key, a preloaded function or by injecting the function as a piece of executable software code. At the same time, the keys act as visual indicators for a user who has access to the IED and can tell at a glance which functions have been enabled. In particular, such a coding may be established by using keys of different colour, preferably luminescent to be visible also in the dark, or by using graphical symbols or IEC 61850 Logical Node designations related to the enabled functions.

In terms of IEC 61850, a Logical Node (LN) is part of a logical device that is itself allocated to an IED. In other words, conventionally the main CPU at the processing module of the IED can be said to host the logical device with all the LNs. Contrary thereto, in a further advantageous variant, a Logical Node (LN) representing the functionality of a particular module is allocated to the respective module as the physical sub-device, i.e. the electronic part of the particular module hosts or represents the LN. In this case, the module itself acts as a server and can be polled, e.g. by the processing module, for the attributes of the LN via the inter-module bus. By way of example, the XML excerpt below represents an instance of a data acquisition Logical Node (TVTR) of a voltage transformer (VTR), with four attributes or data objects (DO).
<LNodeType id="TVTRa" InClass="TVTR">
<DO name="Mod" type="myMod"/>
<DO name="Health" type="myHealth"/>
<DO name="Beh" type="myBeh"/>
<DO name="Vol" type="mySAV"/>
</LNodeType>

An IED with IEC 61850 compatible input modules can then be used in combination with a communication module as a remote intelligent I/O, preferably using the GOOSE-communication method defined in IEC 61850.

### BRIEF DESCRIPTION OF THE DRAWINGS

The subject matter of the invention will be explained in more detail in the following text with reference to preferred exemplary embodiments which are illustrated in the attached drawings, in which:
- Fig.1: shows an Intelligent Electronic Device (IED) with three modules; and
- Fig.2: depicts the IED with a function key attached to a processing module of the IED.

The reference symbols used in the drawings, and their meanings, are listed in summary form in the list of reference symbols. In principle, identical parts are provided with the same reference symbols in the figures.

### DETAILED DESCRIPTION OF PREFERRED EMBODIMENTS

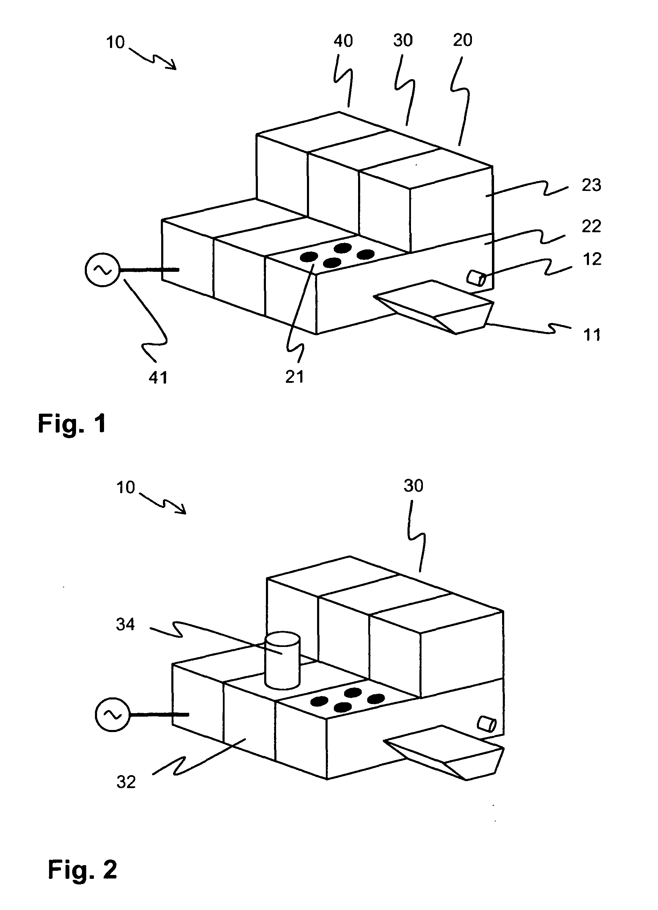

Fig.1 shows an Intelligent Electronic Device (IED) 10 with an I/O module 20, a processing module 30 and a power supply module 40. The modules each comprise a flat housing with a predominant lateral surface and a small front and top side. When mounted on a mechanical support 11, the modules are arranged next to each other and in contact via their respective lateral surfaces. Appropriate openings and contacts in the lateral surfaces allow an inter-module backplane 12 to be established. The housings of the modules form the casing of the IED, i.e. there is no further cover enclosing the modules. The I/O module 20 comprises input terminals 21 to be wired to a sensor device. The I/O module 20 is composed of a base part 22 (bottom), comprising the input terminals 21, and of an electronic part 23 (top) detachable from the base part 22. Power supply module 40 is connected to an auxiliary power supply 41. Additional modules that are not depicted, but that might nevertheless be present in a real IED, comprise a redundant power supply module, a communication module as a gateway for communicating signals to a substation bus, and further binary or analogue Input/Output modules.

Fig.2 depicts an IED 10 with a function coding or activation key 34 engaged in the base part 32 of the processing module 30. The key 34 comprises, on its exterior, a visible code of the functionality enabled by the key. Such a coding may be established by colours, graphical symbols or IEC 61850 Logical Node designations related to the enabled functions.

The inter-module backplane 12 is provided for communication between the modules. Inter-module communication can be done electrically through the backplane with the use of a standard serial communication like USB, CAN, LIN, RS485, ASI, I2C, One-Wire, SPI or similar technologies. Optical or wireless communication based on suitable waveguides can also be used. The communication between the modules can be further achieved by modulating the communication signal on the supply lines, by means of power line communication.

A conventional Current Transformers (CT) generates a signal of 1 A as long as a nominal current flows through the power line to which the CT is attached. This signal is further transformed by a matching transformer that is generally part of an input module. However, bulky matching transformers represent an obstacle to smooth and uniform modularization, i.e. they set a limit to miniaturization, and therefore may be shifted away from the input module and integrated in the CT. Alternatively, the conventional CT may be substituted altogether by a non-conventional current sensor.

Advantageously, in a kind of "hot plug-in" operation, additional modules are added to the IED while the latter is active and running. The additional modules are placed on the mechanical support and connected to the power supply module, while the segmented backplane is extended automatically. The additional module inserted announces its presence to or is detected by the controller of the inter-module bus, and following proper addressing its module functionality is made available to the IED.

### LIST OF DESIGNATIONS

- 10: Intelligent Electronic Device (IED)
- 11: mechanical support
- 12: backplane
- 20: I/O module
- 21: input terminals
- 22: base part
- 23: electronic part
- 30: processing module
- 32: base part
- 34: function activation key
- 40: power supply module
- 41: auxiliary power supply

## Claims

1. An Intelligent Electronic Device (IED) for Substation Automation (SA) or Distribution Automation (DA) systems, comprising, for receiving a signal indicative of a condition of a high or medium voltage power line, an input module (20) with a voltage isolation between a signal input terminal and Protective Earth (PE) in excess of 2 kV, and comprising a processing module (30) for digitally processing the signal,
**characterised in that** the input module (20) and the processing module (30) are individually mountable on a mechanical support (11), and **in that** the input module (20) and the processing module (30) comprise dedicated housings that, when the modules are mounted on the mechanical support, together form a housing of the IED (10).

2. The IED according to claim 1, **characterised in that** it comprises a segmented backplane (12) for inter-module communication.

3. The IED according to claim 1, **characterised in that** a module consists of a base part (22, 32) mountable on the mechanical support (11) and an electronic part (23) detachable from the base part (22).

4. The IED according to claim 1, **characterized in that** the functions of the processing module are enabled by means of a coding key (34).

5. The IED according to claim 4, **characterized in that** the key (34) is coded for visual inspection by means of a colour code or by means of a graphical symbol or Logical Node designating the enabled function.

6. The IED according to claim 1, **characterized in that** an IEC 61850 Logical Node (LN) designating a functionality performed by a particular module (20, 30) of the IED is allocated to said particular module (20, 30).

## Patentansprüche

1. Intelligente elektronische Einrichtung bzw. IED für Systeme der Unterwerkautomatisierung bzw. SA oder Verteilungsautomatisierung bzw. DA mit einem Eingangsmodul (20) zum Empfang eines Signals, das einen Zustand einer Hoch- oder Mittelspannungs-Stromleitung anzeigt, mit einer Spannungsisolation zwischen einem Signaleingangsanschluss und einer Schutzerde bzw. PE von mehr als 2 kV und mit einem Verarbeitungsmodul (30) zum digitalen Verarbeiten des Signals,
**dadurch gekennzeichnet, dass** das Eingangsmodul (20) und das Verarbeitungsmodul (30) einzeln auf einer mechanischen Halterung (11) anbringbar sind und dass das Eingangsmodul (20) und das Verarbeitungsmodul (30) eigene Gehäuse umfassen, die, wenn die Module auf der mechanischen Halterung angebracht sind, zusammen ein Gehäuse der IED (10) bilden.

2. IED nach Anspruch 1, **dadurch gekennzeichnet, dass** sie eine segmentierte Rückwandleiterplatte (12) zur Kommunikation zwischen Modulen umfasst.

3. IED nach Anspruch 1, **dadurch gekennzeichnet, dass** ein Modul aus einem auf der mechanischen Halterung (11) anbringbaren Basisteil (22, 32) und einem von dem Basisteil (22) ablösbaren elektronischen Teil (23) besteht.

4. IED nach Anspruch 1, **dadurch gekennzeichnet, dass** die Funktionen des Verarbeitungsmoduls mittels eines Codierungsschlüssels (34) freigegeben werden.

5. IED nach Anspruch 4, **dadurch gekennzeichnet, dass** der Schlüssel (34) zur visuellen Untersuchung mittels eines Farbcodes oder mittels eines grafischen Symbols oder logischen Knotens, der die freigegebene Funktion kennzeichnet, codiert ist.

6. IED nach Anspruch 1, **dadurch gekennzeichnet, dass** ein logischer Knoten bzw. LN gemäß IEC 61850, der eine durch ein bestimmtes Modul (20, 30) der IED ausgeführte Funktionalität kennzeichnet, an das bestimmte Modul (20, 30) vergeben wird.

## Revendications

1. Dispositif électronique intelligent (IED) pour des systèmes d'automatisation de postes électriques (SA) ou d'automatisation de distribution (DA), comprenant, pour recevoir un signal indiquant un état d'une ligne électrique à haute ou moyenne tension, un module d'entrée (20) bénéficiant d'une isolation de tension entre une borne d'entrée de signal et la terre de protection (PE) supérieure à 2 kV, et comprenant un module de traitement (30) pour appliquer un traitement numérique au signal,
**caractérisé en ce que** le module d'entrée (20) et le module de traitement (30) sont susceptibles d'être montés individuellement sur un support mécanique (11), et **en ce que** le module d'entrée (20) et le module de traitement (30) comprennent des boîtiers dédiés qui, lorsque les modules sont montés sur le support mécanique, forment conjointement un boîtier de l'IED (10).

2. IED selon la revendication 1, **caractérisé en ce qu'**il comprend un fond de panier segmenté (12) pour les communications entre modules.

3. IED selon la revendication 1, **caractérisé en ce qu'**un module se compose d'un partie socle (22, 32) susceptible d'être montée sur le support mécanique (11) et une partie électronique (23) susceptible d'être détachée de la partie socle (22).

4. IED selon la revendication 1, **caractérisé en ce que** les fonctions du module de traitement sont activées au moyen d'une clé de codage (34).

5. IED selon la revendication 4, **caractérisé en ce que** la clé (34) est codée à des fins d'inspection visuelle au moyen d'un code de couleur ou au moyen d'un symbole graphique ou noeud logique désignant la fonction activée.

6. IED selon la revendication 1, **caractérisé en ce qu'**un noeud logique (LN) IEC 61850 désignant une fonctionnalité assurée par un module particulier (20, 30) de l'IED est attribué audit module particulier (20, 30).
